(19) Europäisches Patentamt
European Patent Office
Office européen des brevets

(11) EP 2 575 309 B1

(12) **EUROPEAN PATENT SPECIFICATION**

(45) Date of publication and mention
of the grant of the patent:
**05.11.2014 Bulletin 2014/45**

(51) Int Cl.:
*H04L 25/49* ^(2006.01)   *H03F 3/217* ^(2006.01)
*H04B 10/00* ^(2013.01)

(21) Application number: **11306195.6**

(22) Date of filing: **22.09.2011**

(54) **A method for pulse width modulation, and a transmitter therefor**

Verfahren zur Pulsweitenmodulation und Sender dafür

Procédé de modulation à largeur d'impulsions et transmetteur associé

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**03.04.2013 Bulletin 2013/14**

(73) Proprietor: **ALCATEL LUCENT
92100 Boulogne-Billancourt (FR)**

(72) Inventors:
 • **Haslach, Christoph**
  **70178 Stuttgart (DE)**
 • **Markert, Daniel**
  **70435 Stuttgart (DE)**
 • **Frotzscher, Andreas**
  **70435 Stuttgart (DE)**
 • **Yu, Xin**
  **70435 Stuttgart (DE)**

(74) Representative: **Kleinbub, Oliver
Alcatel-Lucent Deutschland AG
Intellectual Property & Standards
Lorenzstrasse 10
70435 Stuttgart (DE)**

(56) References cited:
**WO-A1-03/055059          GB-A- 2 456 889
US-A1- 2006 140 644    US-A1- 2008 161 953
US-B1- 6 762 704**

 • **ALBERT GARCIA I TORMO ET AL: "Multi-Level
asynchronous Î GBP Î modulators for wideband
switching power amplifiers", CONTROL AND
MODELING FOR POWER ELECTRONICS
(COMPEL), 2010 IEEE 12TH WORKSHOP ON,
IEEE, PISCATAWAY, NJ, USA, 28 June 2010
(2010-06-28), pages 1-8, XP031746267, ISBN:
978-1-4244-7462-2**
 • **ROSNELL S ET AL: "Bandpass pulse-width
modulation (BP-PWM)", 2005 IEEE MTT-S
INTERNATIONAL MICROWAVE SYMPOSIUM,
PISCATAWAY, NJ, USA,IEEE, 12 June 2005
(2005-06-12), pages 731-734, XP010844573, DOI:
10.1109/MWSYM.2005.1516714 ISBN:
978-0-7803-8846-8**

## Description

### Field of the invention

The invention relates to a method for pulse width modulation of a signal using a transmitter with at least two pulse width modulators, and a transmitter adapted to perform said method.

### Background

In order to support highly efficient switching power amplifiers, time continuous signals with continuous amplitude, or multi-level signals, need to be converted to time continuous 2-level signals. In general, this transformation is executed by so-called delta sigma modulators (DSM), also called sigma delta modulators, or pulse length modulators (PLM), also called pulse width modulators (PWM).

These so-called pulse width modulators (PWM) are promising modulator concepts in the context of switching amplifiers, e.g. for highly efficient switching power amplifiers used for the amplification of radio signals to be transmitted over an air interface in a communication network. In principle, they allow for an ideal conversion of signals with continuous amplitude and limited bandwidth to a time continuous 2-level signal. This 2-level signal is perfectly suited for switching amplifier stages. The 2-level signal can be reconverted to the continuous amplitude signal simply by a reconstruction filter after the amplification stage.

Further applications of pulse width modulators comprise the control of the supply of electrical power for other devices such as in speed control of electric motors, operation of so-called class D audio switching amplifiers or brightness control of light sources.

### Summary

There exist numerous pulse width modulator architectures, but they either suffer from low coding efficiency, spectral deterioration, high sampling frequencies and/or difficulties in implementations. The typical class S setup employing a pulse width modulator looks as follows: an analogue signal is converted to a time continuous 2-level signal, e.g. a switching signal, by a pulse width modulator. The resulting signal is amplified by a switching amplifier. The amplified signal is reconverted to a time- and amplitude-continuous signal by a reconstruction filter, which can be a low pass or band pass filter. This filter erases, i.e. attenuates, the out-of-band signal components. If there are many and strong out-of-band signal components, also refered to as quantization noise, this results in strict requirements for the filter characteristics and the termination conditions of this filter. Any non-idealities in these characteristics result in power losses and/or spectral deterioration. Hence, it is important to have a pulse width modulator architecture, that generates a switching signal with a minimum of signal components in the out-of-band region. This means, the coding efficiency of the switching signal, defined as the ratio of the wanted signal power at the carrier frequency and the total signal power, shall be as high as possible.

In principle, an analogue implementation of a pulse width modulator works as described in the following.

A signal with a continuous amplitude is fed to a comparator as a first input signal. The second input signal to the comparator is a sawtooth signal or a triangular signal. In the following only the sawtooth signal is mentioned, but the considerations are valid for triangular signals too. As soon as the ascending amplitude of the sawtooth signal has the same value as the continuous amplitude signal, the output of the comparator switches from voltage-high (VH) to voltage-low (VL). The falling edge of the sawtooth signal resets the output of the comparator to voltage high (VH). The output of the comparator is the PWM signal.

Depending on the implementation, the first input signal of the comparator may also be the sampled version of the continuous amplitude signal, sampled at equidistant time instances.

Simulation results of such a pulse width modulator according to the state of the art for a UMTS signal (UMTS = Universal Mobile Telecommunications System) testmodel 3 with 5 MHz bandwidth and 5.6dB Peak to Average Power Ratio (PAPR), and with the carrier frequency of the UMTS signal being 2.14GHz, and the frequency of the triangular trigger (reference) signal being 5GHz, show that the wanted signal at 2.14GHz only contains a small fraction of the total signal power. The majority of signal power is allocated at the first harmonic component of the reference signal at 5GHz. As a consequence, the coding efficiency is only 11.98% in this case.

In order to come to a method for signal amplification that has high coding efficieny, low pulse rates and a simple structure that simplifies implementation and improves energy efficiency, the principle to create out of an input signal a distributed multi-level pulse width modulated signal which is composed out of 2-level pulse width modulated signals at carrier frequency, and to amplify said 2-level pulse width modulated signals applying the principle of switching power amplification is used.

In the US patent US 6,762,704 B1, a method is disclosed for modulating a digital input signal using multiple digital signal modulators. Summers are used to modify the input signal with a bias signal which is generally set in a range that is high enough to minimize nonlinearities and low enough to minimize voltage swing reductions. 3-level modulated signals can be generated using phase shifted clock frequencies.

Simulations show that applying said method for signal amplification leads to the majority of the signal power being now located at the wanted carrier frequency. The coding efficiency is higher than 60% now using the above-described UMTS signal with 5.6 dB PAPR, compared to 11.98% using a pulse width modulator according to the state of the art for the same input signal.

For creation of said distributed multi-level pulse width modulated signal, preferably at least one pulse width modulator comprising a comparator with a comparator threshold is used. Each time an ascending input signal crosses the comparator threshold, a start of a pulse is triggered, and each time a descending input signal crosses the comparator threshold, an end of a pulse is triggered, which leads to pulses with a dedicated width and position.

In order to create a pulse for a half wave of the input signal at carrier frequency, the envelope of the input signal must be higher than the comparator threshold. Thus, the comparator threshold must be regulated in real time dependent on the envelope of the input signal. However, such a real time evaluation of the envelope of the input signal, and such a real time regulation of the comparator threshold at carrier frequency is complex and requires some effort.

The object of the invention is thus to propose a method for pulse width modulation using a pulse width modulator comprising a comparator with a comparator threshold that avoids such a complex real time regulation of the comparator threshold.

The basic idea of the invention is to perform a pre-emphasis of an input signal preferably at a baseband sampling rate dependent on a fix comparator threshold, which leads to a pre-emphasized signal with a magnitude that is higher than the fix comparator threshold. In other words, not the comparator threshold is regulated, but a pre-emphasis of the input signal based on the fix comparator threshold is performed, i.e. the input signal is adjusted based on the fix comparator threshold.

The object is thus achieved by a method for pulse width modulation of a signal using at least two pulse width modulators according to claim 1.

The object is furthermore achieved by a transmitter comprising at least two pulse width modulators for pulse width modulation of a signal according to claim 10.

Further features and advantages are stated in the following description of exemplary embodiments, with reference to the figures, which shows significant details, and are defined by the claims. The individual features can be implemented individually by themselves, or several of them can be implemented in any desired combination.

**Brief description of the figures**

In the following the invention will be explained further making reference to the attached drawings.

Fig. 1 schematically shows a pulse width modulator according to the state of the art.

Fig. 2 shows a spectrum plot of a power spectral density of a pulse width modulated signal according to the state of the art.

Fig. 3 schematically shows an analogue radio frequency input signal and two constant comparator thresholds $c_1$ and $-c_1$ for pulse width modulation.

Fig. 4 schematically shows two pulse width modulated signals which result as output signals of an analogue radio frequency input signal after pulse width modulation in a first and a second pulse width modulator with a constant first and a constant second comparator threshold respectively.

Fig. 5 schematically shows a 3-level pulse width modulated signal which results after combination of the two pulse width modulated signals depicted in fig. 4. In the following the term ternary is used as a synonym of the term 3-level.

Fig. 6 shows a spectrum plot of a power spectral density of a ternary pulse width modulated signal as depicted in fig. 5.

Fig. 7 schematically shows exemplarily a pulse that results from comparison of a time signal at carrier frequency with a comparator threshold.

Fig. 8 schematically shows exemplarily 3 pulses plotted against time and phase respectively that result from comparison of a signal at carrier frequency with 2 comparator thresholds according to fig. 5.

Fig. 9 schematically shows exemplarily two transmitters for amplification of distributed ternary pulse width modulated signals using pre-emphasis of a signal at baseband level, and two pulse width modulators according to two embodiments of the invention.

Fig. 10 schematically shows exemplarily a transmitter for amplification of distributed ternary pulse width modulated signals using two pulse width modulators and separate switching power amplifiers according to an embodiment of the invention.

Fig. 11 schematically shows exemplarily a transmitter for amplification of distributed ternary pulse width modulated signals using two pulse width modulators, an inverter and a differential switching power amplifier according to an embodiment of the invention.

Fig. 12 schematically shows exemplarily a transmitter for amplification of distributed ternary pulse width modulated signals using two pulse width modulators, and a differential switching power amplifier according to an embodiment of the invention.

Fig. 13 schematically shows exemplarily a transmitter for amplification of distributed ternary pulse width modulated signals using a pulse width modulator, a splitter, a phase shifter and a differential switching power amplifier according to an embodiment of the invention.

Fig. 14 schematically shows exemplarily a transmitter for amplification of distributed ternary pulse width modulated signals using two pulse width modulators, two electro-optical converters and an optical combiner for optical transmission of pulse width modulated signals to switching power amplifiers according to an embodiment of the invention.

Fig. 15 schematically shows exemplarily a transmitter for amplification of distributed ternary pulse width modulated signals according to fig. 9, with additionally two electro-optical converters and two opto-electrical converters for optical transmission of pulse width modulated signals to the differential switching power amplifier according to an embodiment of the invention.

Fig. 16 schematically shows exemplarily a transmitter for amplification of distributed ternary pulse width modulated signals according to fig. 10, with additionally an electro-optical converter and an opto-electrical converter for optical transmission of pulse width modulated signals to the differential switching power amplifier according to an embodiment of the invention.

Fig. 17 schematically shows exemplarily a transmitter for amplification of distributed ternary pulse width modulated signals according to fig. 12, with additionally an optical multiplexer and an optical demultiplexer for combined optical transmission of pulse width modulated signals to the differential switching power amplifier according to an embodiment of the invention.

Fig. 18 schematically shows a differential switching power amplifier architecture relying on a voltage switched circuit topology according to the state of the art.

Fig. 19 schematically shows a differential switching power amplifier architecture relying on a current switched circuit topology according to the state of the art.

**Description of the embodiments**

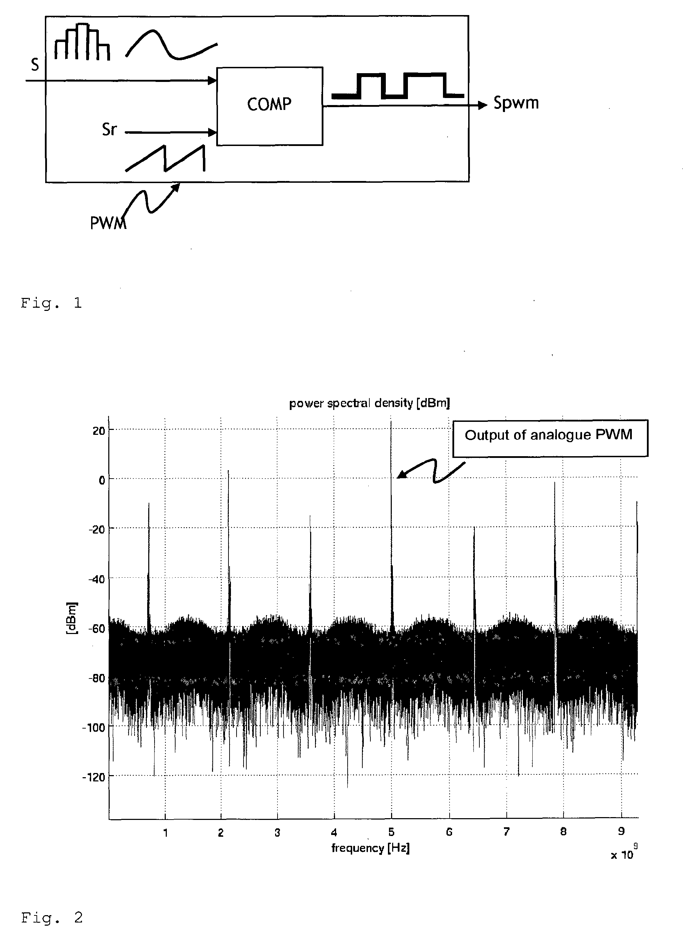

Fig. 1 schematically shows a pulse width modulator PWM according to the state of the art comprising as a basic part a comparator COMP with two inputs and one output.

Depending on the implementation, the input signal S of the pulse width modulator PWM can either be a signal with continuous amplitude, or the sampled version of the continuous amplitude signal, sampled at equidistant time instances.

The input signal S is fed to the first input of the comparator COMP, and a sawtooth signal Sr is fed to the second input of the comparator COMP. As soon as the ascending amplitude of the sawtooth signal Sr has the same value as the input signal S, the output of the comparator switches from voltage-high (VH) to voltage-low (VL) and remains at VL as long as $Sr \geq S$ holds. The falling edge of the sawtooth signal Sr resets the output of the comparator to voltage high (VH). The pulse width modulated signal Spwm is transmitted from the output of the comparator COMP to the output of the pulse width modulator PWM.

Fig. 2 shows a simulation of a spectrum plot of a power spectral density of a pulse width modulated signal using the pulse width modulator PWM depicted in fig. 1 for a 5MHz UMTS signal test model 3 with 5 MHz bandwidth and 5.6dB Peak to Average Power Ratio (PAPR). The carrier frequency of the UMTS signal is 2.14GHz, the repetition frequency of a triangular trigger signal, i.e. reference signal, is 5GHz. It can be seen, that the wanted 2.14GHz spectral component only contains a small fraction of the total signal power. The majority of signal power is allocated at the first harmonic component of the reference signal at 5GHz. As a consequence, the coding efficiency is only 11.98% in this case.

In order to come to a method for signal amplification that has high coding efficieny, low pulse rates and a simple structure that simplifies implementation and improves energy efficiency, the principle to create out of an input signal a distributed multi-level pulse width modulated signal which is composed out of 2-level pulse width modulated signals at carrier frequency, and to amplify said 2-level pulse width modulated signals applying the principle of switching power amplification is used.

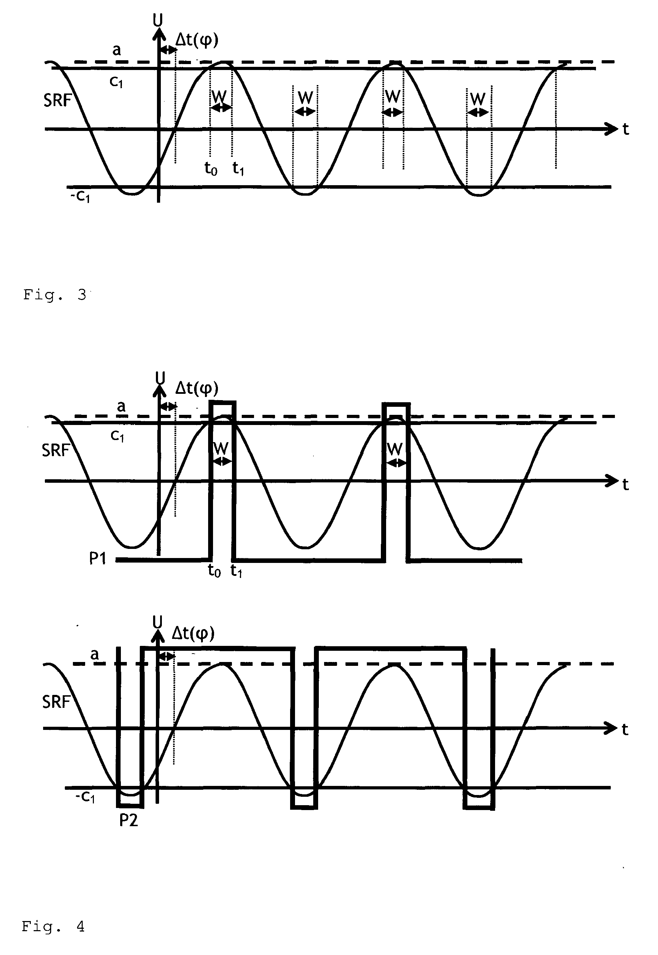

In fig. 3, a signal strength of a signal $SRF = a*\sin(2\pi f_c t + \varphi)$ is plotted against time t, with a being the envelope of the signal SRF, $f_c$ being the carrier frequency, and $\varphi$ being the phase of the signal SRF. In this example, a is only slowly varying compared to the term $\sin(2\pi f_c t)$. The two solid lines refer to two fix comparator thresholds $c_1$ and $-c_1$ respectively, which can be implemented e.g. in two 2-level pulse width modulators as will be described later. In the following the term binary is used as synonym of the word 2-level.

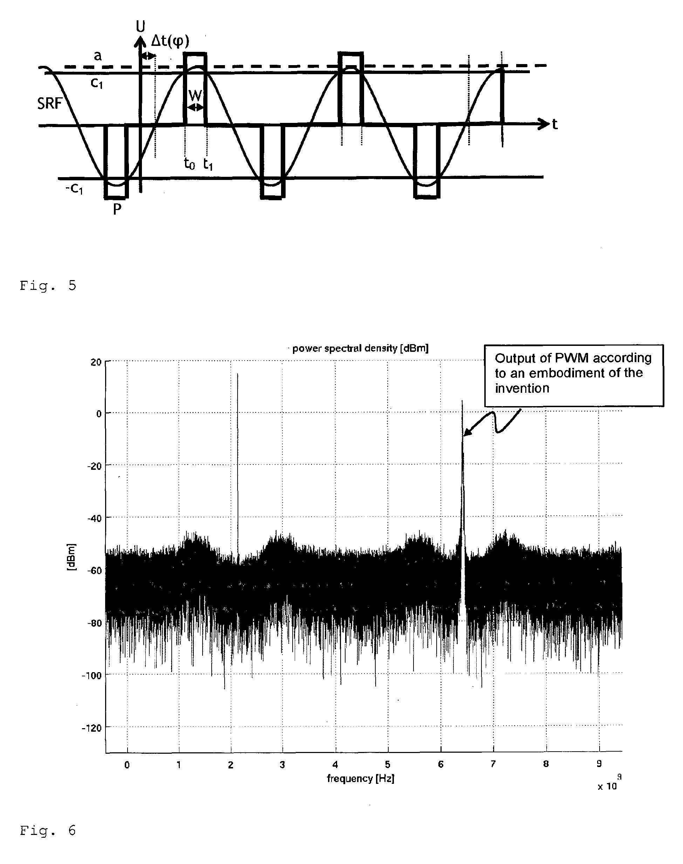

Each time an ascending signal SRF crosses the first comparator threshold $c_1$, a start of a pulse is triggered e.g. at time to as depicted in fig. 3, and each time a descending signal SRF crosses the first comparator threshold $c_1$, an end of a pulse is triggered e.g. at time $t_1$ as depicted in fig. 3, which leads to pulses with a width W. In an analogue manner, each time a descending signal SRF crosses the second comparator threshold $- C_1$, a start of a negative pulse is triggered, and each time an ascending signal SRF crosses the second comparator threshold $- C_1$, an end of a negative pulse is triggered, which also leads to pulses with a width W. Said pulses with the width W are depicted in fig. 4 and described below. In other words, each positive carrier half wave causes a positive pulse and each negative half wave causes a negative pulse. Between positive pulses and negative pulses and between negative pulses and positive pulses, the resulting signal after combining the signals from fig. 4 is set to 0, or generally (VH+VL)/2, which is depicted in fig. 5. Thus, applying said pulse width modulation method leads to a ternary pulse width modulated signal with a zero line, and positive and negative pulses.

The ternary pulse width modulated signal can be generated by combining two devices, e.g. two pulse width modulators, each with the functionality of a comparator, where the first device generates the positive pulses, and the second device generates the negative pulses.

In the upper diagram in fig. 4, as in fig. 3, a signal strength of a signal $SRF = a*\sin(2\pi f_c t + \varphi)$ is plotted against time t, with a being the envelope of the signal SRF, $f_c$ being the carrier frequency, and $\varphi$ being the phase of the signal SRF. Additionally, pulses P1 are depicted resulting from a comparison of the signal SRF with the first comparator threshold $c_1$ as described above under fig. 3.

In the lower diagram in fig. 4, as in fig. 3, a signal strength of a signal $SRF = a*\sin(2\pi f_c t + \varphi)$ is plotted against time t, with a being the envelope of the signal SRF, $f_c$ being the carrier frequency, and $\varphi$ being the phase of the signal SRF. Additionally, pulses P2 are depicted resulting from a comparison of the signal SRF with the second comparator threshold $-c_1$ as described above under fig. 3.

In the diagram in fig. 5, as in fig. 3, a signal strength of a signal $SRF = a*\sin(2\pi f_c t + \varphi)$ is plotted against time t, with a being the envelope of the signal SRF, $f_c$ being the carrier frequency, and $\varphi$ being the phase of the signal SRF. Additionally, the desired ternary pulse width modulated signal P is depicted which results after adding the pulses P1 resulting from a comparison of the signal SRF with the first comparator threshold $c_1$ to the pulses P2 resulting from a comparison of the signal SRF with the second comparator threshold $-c_1$, as depicted in fig. 4.

As already mentioned above, each positive carrier half wave causes a positive pulse and each negative half wave causes a negative pulse. Between positive pulses and negative pulses and between negative pulses and positive pulses, the ternary pulse width modulated signal P is set to 0. The ternary pulse width modulated signal P can be generated by combining two devices, e.g. two pulse width modulators, each with the functionality of a comparator, where one device generates the positive pulses and the other one generates the negative pulses.

Fig. 6 shows a simulation of a spectrum plot of a power spectral density of a ternary pulse width modulated signal P as depicted in fig. 5 for a UMTS signal test model 3 with 5 MHz bandwidth and 5.6dB Peak to Average Power Ratio (PAPR). The carrier frequency of the UMTS signal is 2.14GHz. The majority of the signal power is now located at the wanted carrier frequency at 2.14GHz. The coding efficiency is higher than 60% in this case, compared to 11.98% in the case a conventional pulse width modulator as depicted in fig. 1 is used for the same input signal. Another crucial advantage is apparent: The requirements for a reconstruction filter can be relaxed significantly, as the quantization noise power is drastically reduced and the spectrum in the vicinity of the carrier frequency is much cleaner. Furthermore, the spectrum from direct current (DC) to the carrier frequency $f_c$ is without any distortion peak.

As already mentioned above, in order to be sure to create a pulse for a half wave of a signal at carrier frequency, according to the invention, a pre-emphasis of the signal dependent on a comparator threshold must be performed, which leads to a pre-emphasized signal with a magnitude that is higher than the comparator threshold.

In the following, a correlation between the magnitude of a complex valued baseband signal SBB and the magnitude of a complex valued pre-emphasized baseband or carrier frequency signal SRF is deduced in order to be able to perform an appropriate pre-emphasis.

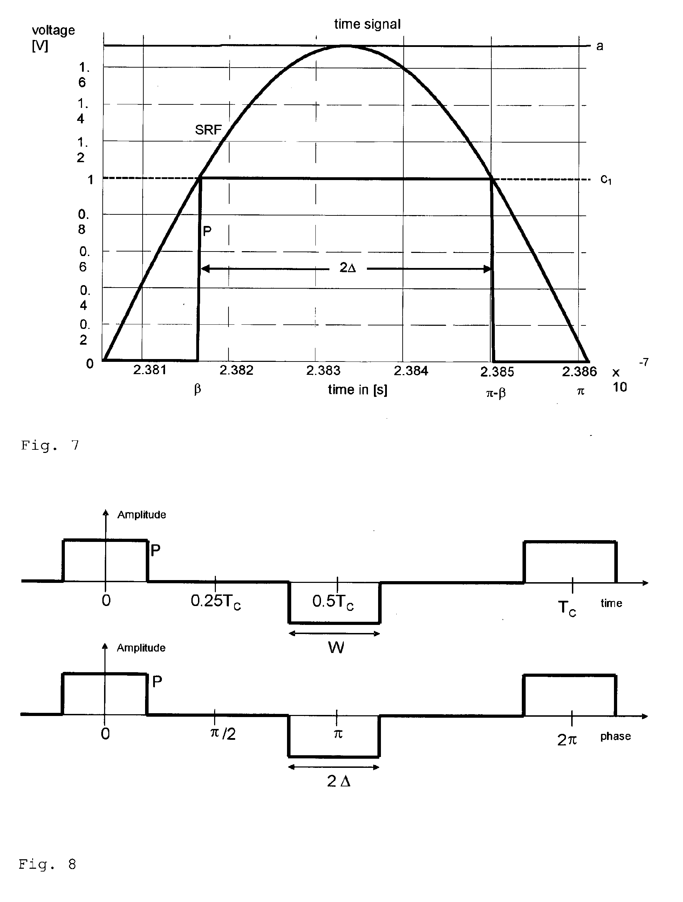

Fig. 7 schematically shows exemplarily a pulse P that results from comparison of a time signal SRF at carrier frequency with a comparator threshold $c_1$.

Consider the pulse P that is generated by an ideal comparator with a comparator threshold, i.e. reference threshold, $c_1=1V$. The envelope $a=|SRF|$, which corresponds to a magnitude $a=|SPR|$ of a pre-emphasized baseband signal SPR as e.g. depicted in the second transmitter in fig, 9 and described in more detail below, is depicted as a solid line, the analogue sinusoidal input to the comparator, i.e. the pre-emphasized baseband signal SRF modulated at carrier frequency $f_c$, is depicted as a solid curve.

A sinusoidal wave SRF with an envelope $a$ yields rectangular pulses P of width $W$ if it is fed to an ideal comparator with comparator threshold $c_1$. The value $2\Delta$ is the corresponding pulse width in radiant.

The following formula can be derived from fig. 7:

$$a \cdot \sin(\beta) = c_1 \qquad (1)$$

$$2\Delta = \pi - 2 \cdot \beta \qquad (2)$$

$$2\Delta = \pi - 2 \cdot \arcsin\left(\frac{c_1}{a}\right) \qquad (3)$$

W is the pulse width in seconds and it holds

$$W = \frac{2\Delta}{2\pi f_c} = \frac{\Delta}{\pi f_c} = \frac{\Delta \cdot T_c}{\pi} \qquad (4)$$

$$\Delta = W \cdot \pi \cdot f_c \qquad (5)$$

Now consider a periodic ternary pulse width sequence which corresponds e.g. to the pulses P in fig. 5. The periodicity, i.e. the period of duration $T_c$, in this example corresponds to a signal with constant absolute value in the baseband as e.g. the signal SRF in fig. 5.

Fig. 8 schematically shows exemplarily 3 periodic ternary pulses P with a period of duration $T_c$ plotted against time in the upper diagram and phase in the lower diagram respectively that result from comparison of a signal at carrier frequency with 2 comparator thresholds according to fig. 5.

The Fourier transformation of a periodic ternary pulse width sequence yields the following Fourier coefficient $b_1$ for the fundamental frequency $f_c = \dfrac{1}{T_c}$ :

$$b_1 = \frac{4}{\pi} \cdot \sin(\pi \cdot f_c \cdot W) \qquad (6)$$

with

$$\frac{W}{T_c} = W \cdot f_c = \frac{2\Delta}{2\pi} = \frac{\Delta}{\pi} \qquad (7)$$

This means that a reconstruction filter, as e.g. a bandpass filter with passband at frequency $f_c$ converts a periodical ternary pulse sequence with pulse width $W$ into a continuous wave (CW) signal with frequency $f_c$ and envelope $E$ with

$$E = M \cdot \frac{4}{\pi} \cdot \sin(\pi \cdot f_c \cdot W) = M \cdot \frac{4}{\pi} \cdot \sin(\Delta)$$

Using equation (3) one gets

$$E = M \cdot \frac{4}{\pi} \cdot \sin\left(\frac{\pi}{2} - \arcsin\left(\frac{c_1}{a}\right)\right) = M \cdot \frac{4}{\pi} \cdot \cos\left(\arcsin\left(\frac{c_1}{a}\right)\right) = M \cdot \frac{4}{\pi} \cdot \sqrt{1 - \left(\frac{c_1}{a}\right)^2} \, ,$$

where $M$ is a constant factor that represents the amplification and attenuation of the involved components.

In order to achieve a linear behaviour of the magnitude of the baseband signal $SBB$ and a reconstructed envelope $E = M \cdot \frac{4}{\pi} \cdot \sqrt{1 - \left(\frac{c_1}{a}\right)^2}$ , the pre-emphasis $SPR = g(SBB)$ must be chosen such that the following equation holds:

$$E = M \cdot \frac{4}{\pi} \cdot \sqrt{1 - \left(\frac{c_1}{|SPR|}\right)^2} = K \cdot |SBB|$$

Hence,

$$\left(\frac{4 \cdot M}{\pi K}\right)^2 \cdot \left(1 - \left(\frac{c_1}{|SPR(SBB)|}\right)^2\right) = |SBB|^2$$

$$1 - \left(\frac{c_1}{|SPR(SBB)|}\right)^2 = \left(|SBB| \cdot \frac{\pi \cdot K}{4 \cdot M}\right)^2$$

$$1 - \left( |SBB| \cdot \frac{\pi \cdot K}{4 \cdot M} \right)^2 = \frac{c_1^{\ 2}}{|SPR(SBB)|^2}$$

$$|SPR(SBB)|^2 = \frac{c_1^{\ 2}}{1 - \left( |SBB| \cdot \frac{\pi \cdot K}{4 \cdot M} \right)^2} ,$$

which finally results in

$$|SPR(SBB)| = \frac{c_1}{\sqrt{1 - \left( \frac{|SBB|}{SBB_{max}} \right)^2}} \qquad (8)$$

and angle (SPR) = angle(SBB) with $SBB_{max} = \dfrac{4 \cdot M}{\pi \cdot K}$

In other words, from equation (8) follows, that there is always a pulse P generated, if $SBB_{max}$ is chosen in such a way, that it is always higher than the maximum amplitude of the baseband signal $SBB$, as in this case $|SPR(SBB)| > c_1$. Thus, $SBB_{max}$ can be seen as the maximum allowed or possible value for the magnitude of the baseband signal $SBB$.

If the maximum magnitude of the baseband signal $SBB$ is smaller than $SBB_{max}$, the system is operated with so-called peak power back off (PBO). Due to the fact that $|SPR(SBB)|$ goes to infinity for $SBB \rightarrow SBB_{max}$ the system will always be operated with a certain PBO, which can be small and depends e.g. from the resolution of the employed digital to analogue converters (DACs).

In an embodiment of the invention, the correlation between the magnitude of the complex valued baseband signal SBB and the magnitude of the complex valued pre-emphasized baseband signal SPR or the envelope of the carrier frequency signal SRF as given in equation (8) can be approximated using a Taylor series expansion.

The Taylor series expansion $P_f(x)$ of a function $f(x)$ is determined as following:

$$P_f(x) = f(0) + \frac{f'(0)}{1}x + \frac{f''(0)}{2!}x^2 + \dots$$

The following factors result for the Taylor series expansion of equation (8):

$$|SPR(0)| = c_1$$

$$|SPR(0)|' = 0$$

$$\left| SPR(0) \right|'' = \frac{c_1}{SBB_{\max}}$$

Thus, the Taylor series expansion of equation (8) is as follows:

$$\left| SPR(SBB) \right| = c_1 + \frac{c_1}{2 SBB_{\max}} \left| SBB \right|^2 + \ldots \qquad (9)$$

As a result, the pre-emphasis of the complex valued baseband signal SBB is dependent on the comparator threshold $c_1$ and on $SBB_{\max}$ which must be chosen higher than the maximum magnitude of the baseband signal $SBB$. As the comparator threshold $c_1$ and $SBB_{\max}$ are known, a value for the pre-emphasis can be calculated either according to equation (8), or according to equation (9), i.e. to a truncated Taylor series expansion.

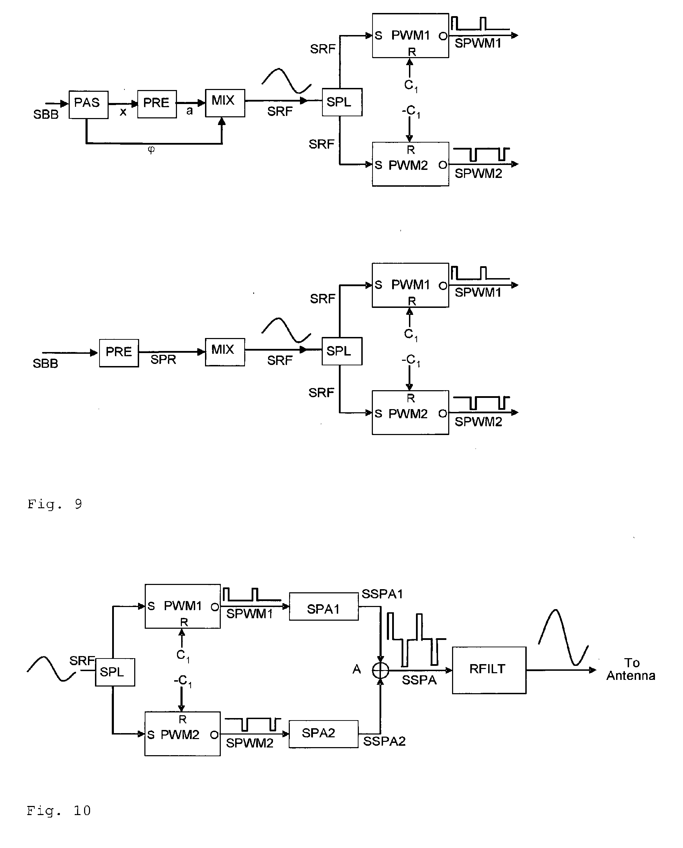

Fig. 9 schematically shows exemplarily two transmitters for amplification of distributed ternary pulse width modulated signals using pre-emphasis of a signal at baseband level as described above, and two pulse width modulators according to two embodiments of the invention.

The first transmitter in fig. 9 comprises a phase-amplitude-splitter PAS, an entity for pre-emphasis PRE, a mixer MIX, a splitter or coupler SPL, and a first and a second pulse width modulator PWM1, PWM2.

A complex valued baseband signal SBB is transferred into a polar representation of phase $\varphi$ and magnitude x in the phase-amplitude-splitter PAS. In the entity for pre-emphasis PRE, a pre-emphasis of the magnitude x according to equation (8) and (9) respectively is performed resulting in a pre-emphasized magnitude a. With this pre-emphasis, the amplitude distortion of the wanted radio signal x*sin ($2\pi f_c t + \varphi$) caused by a pulse width modulation as described below is pre-compensated.

The phase $\varphi$ is transmitted from the phase-amplitude-splitter PAS to the mixer MIX, and the pre-emphasized magnitude a is transmitted from the entity for pre-emphasis PRE to the mixer MIX.

In the mixer MIX, the incoming signals of the pre-emphasized magnitude a and the phase $\varphi$ are upconverted to a pre-emphasized signal SRF= a*sin ($2\pi f_c t + \varphi$) at carrier frequency $f_c$, and transmitted to the splitter or coupler SPL.

In another embodiment of the invention, a pre-emphasis of the complex valued baseband signal SBB can also be executed prior to a transformation into a polar representation of phase $\varphi$ and magnitude x in the phase-amplitude-splitter PAS, i.e. the entity for pre-emphasis PRE is exchanged with the phase-amplitude-splitter PAS in fig. 9.

The complex valued pre-emphasized radio frequency signal SRF=a*sin ($2\pi f_c t + \varphi$) is duplicated by means of the splitter or coupler SPL. As in the embodiment in fig. 9 only the functionality of a splitter is required, the usage of a splitter SPL is preferred.

The pre-emphasized radio frequency signal SRF is transmitted to a signal input of the first pulse width modulator PWM1, and a first comparator threshold $c_1$ is fed to a reference input of the first pulse width modulator PWM1. As depicted in the upper diagram in fig. 4 and described above, a first pulse width modulated signal SPWM1 results from a comparison of the pre-emphasized radio frequencysignal SRF with the first comparator threshold $c_1$, and said first pulse width modulated signal SPWM1 is sent to an input of a switching power amplifier, which is however not depicted in fig. 9 for the sake of simplicity.

The pre-emphasized radio frequency signal SRF is also transmitted to a signal input of the second pulse width modulator PWM2, and a second comparator threshold $-c_1$ is fed to a reference input of the second pulse width modulator PWM2. As depicted in the lower diagram in fig. 4 and described above, a second pulse width modulated signal SPWM2 results from a comparison of the pre-emphasized radio frequency signal SRF with the second comparator threshold $-c_1$, and said second pulse width modulated signal SPWM2 is sent to an input of a switching power amplifier, which is however not depicted in fig. 9 for the sake of simplicity.

The pulse width modulators PWM1 and PWM2 have the functionality of a comparator. If the signal at the input S of the block is larger than the signal at the input R, the output signal at the output O is "+1", otherwise, the output signal at the output O is "-1". In a concrete embodiment, the pulse width modulators PWM1 and PWM2 may be implemented as a dedicated comparator or as a limiting amplifier with differential input ports.

In an alternative, but equivalent embodiment, the pulse width modulators PWM1 and PWM2 have a binary output alphabet with values '0' and '1' and the output of the second pulse width modulator PWM2 is subtracted from the output of the first pulse width modulator PWM1. For amplification, a so-called differential switching power amplifier is used as described in some embodiments below.

The values "+1" ,"0" and "-1" have a symbolic meaning here. If the levels represent voltages, "+1" and "-1" represent two different voltages, and "0" represents the mean of these two voltages.

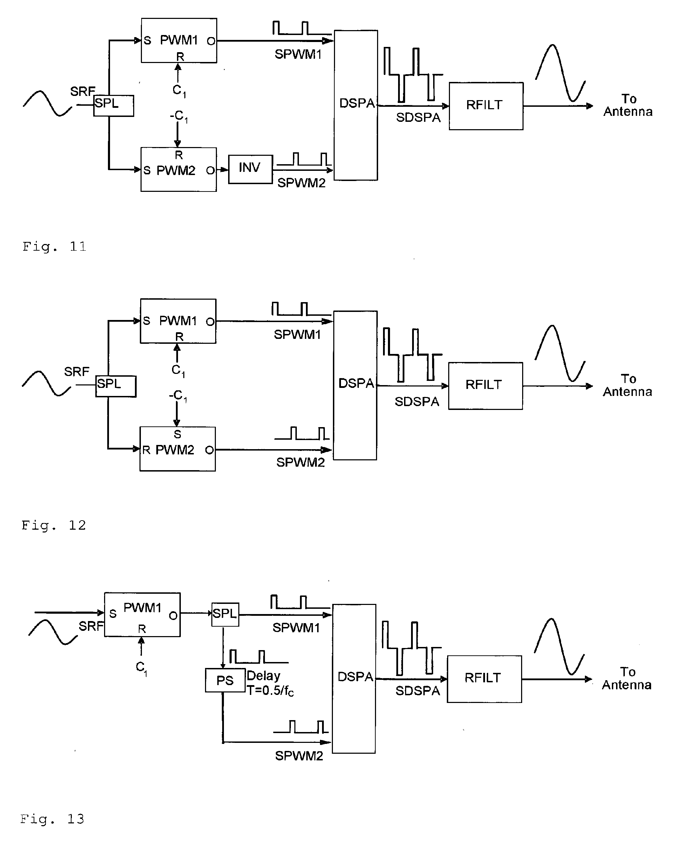

It turns out that the output signals of the pulse width modulators PWM1 and PWM2 look very similar. They can be approximated as delayed and inverted copies of each other as long as the carrier frequency is much higher than the band width of the baseband signal. This fact can be exploited to save one pulse width modulator as depicted in fig. 13 and described below.

The second transmitter in fig. 9 comprises an entity for pre-emphasis PRE, a mixer MIX, a splitter or coupler SPL, and a first and a second pulse width modulator PWM1, PWM2.

In the entity for pre-emphasis PRE, a pre-emphasis of the complex valued baseband signal SBB is performed by pre-emphasis of the absolute value of the complex valued baseband signal SBB, which results in a pre-emphasized baseband signal SPR with a magnitude $a = |SPR|$.

The pre-emphasized baseband signal SPR is transmitted from the entity for pre-emphasis PRE to the mixer MIX.

In the mixer MIX, the pre-emphasized baseband signal SPR is upconverted to a pre-emphasized signal $SRF = a*\sin(2\pi f_c t + \varphi)$ at carrier frequency $f_c$, and transmitted to the splitter or coupler SPL.

The further processing of the signals is as described above for the first transmitter in fig. 9.

A requirement for using multi-level pulse width modulated signals, as e.g. ternary pulse width modulated signals P as described above, is that the multi-level pulse width modulated signals need to be amplified. Thus, several transmitters for amplification of distributed ternary pulse width modulated signals as an example of distributed multi-level pulse width modulated signals are described in the following according to several embodiments of the invention.

Fig. 10 schematically shows exemplarily a transmitter for amplification of distributed ternary pulse width modulated signals using two pulse width modulators and separate switching power amplifiers according to an embodiment of the invention.

The transmitter comprises a splitter or coupler SPL, a first and a second pulse width modulator PWM1, PWM2, a first and a second switching power amplifier SPA1, SPA2, an adder A, and a reconstruction filter RFILT.

A pre-emphasized radio frequency signal $SRF = a*\sin(2\pi f_c t + \varphi)$ as described above is duplicated by means of the splitter or coupler SPL. As in the embodiment in fig. 10 only the functionality of a splitter is required, the usage of a splitter SPL is preferred.

The pre-emphasized radio frequency signal SRF is transmitted to a signal input of the first pulse width modulator PWM1, and a first comparator threshold $c_1$ is fed to a reference input of the first pulse width modulator PWM1. As depicted in the upper diagram in fig. 4 and described above, a first pulse width modulated signal SPWM1 results from a comparison of the pre-emphasized radio frequency signal SRF with the first comparator threshold $c_1$, and said first pulse width modulated signal SPWM1 is sent to an input of the first switching power amplifier SPA1.

In the first switching power amplifier SPA1, said first pulse width modulated signal SPWM1, which is a binary pulse width modulated signal, is amplified resulting in an amplified copy SSPA1 of the first pulse width modulated signal SPWM1.

The pre-emphasized radio frequency signal SRF is also transmitted to a signal input of the second pulse width modulator PWM2, and a second comparator threshold $-c_1$ is fed to a reference input of the second pulse width modulator PWM2. As depicted in the lower diagram in fig. 4 and described above, a second pulse width modulated signal SPWM2 results from a comparison of the pre-emphasized radio frequency signal SRF with the second comparator threshold $-c_1$, and said second pulse width modulated signal SPWM2 is sent to an input of the second switching power amplifier SPA2.

In the second switching power amplifier SPA2, said second pulse width modulated signal SPWM2, which is a binary pulse width modulated signal, is amplified resulting in an amplified copy SSPA2 of the second pulse width modulated signal SPWM2.

The amplified copy SSPA1 of the first pulse width modulated signal SPWM1, and the amplified copy SSPA2 of the second pulse width modulated signal SPWM2 are added in the adder A resulting in a ternary signal SSPA.

The ternary signal SSPA is then filtered in a reconstruction filter RFILT preferably of low pass or band pass type for converting the digital ternary signal SSPA into an amplified copy of the upconverted baseband signal SBB. Said ternary signal SSPA corresponds to an amplified copy of a ternary pulse width modulated signal as e.g. depicted in fig. 5.

Thus, according to the embodiment of the invention the two output signals of the two pulse width modulators SPWM1 and SPWM2 are amplified separately in two switching power amplifiers SPA1 and SPA2, as it is easier to amplify binary pulse width modulated signals than ternary pulse width modulated signals.

Fig. 11 schematically shows exemplarily a transmitter for amplification of distributed ternary pulse width modulated signals using two pulse width modulators, an inverter and a differential switching power amplifier according to an embodiment of the invention.

The transmitter comprises a splitter or coupler SPL, a first and a second pulse width modulator PWM1, PWM2, a signal inverter INV, a differential switching power amplifier DSPA, and a reconstruction filter RFILT.

A pre-emphasized radio frequency signal $SRF = a*\sin(2\pi f_c t + \varphi)$ as described above is duplicated by means of the splitter or coupler SPL. As in the embodiment in fig. 11 only the functionality of a splitter is required, the usage of a splitter SPL is preferred.

The pre-emphasized radio frequency signal SRF is transmitted to a signal input of the first pulse width modulator PWM1, and a first comparator threshold $c_1$ is fed to a reference input of the first pulse width modulator PWM1. As depicted in the upper diagram in fig. 4 and described above, a first pulse width modulated signal SPWM1 results from a comparison of the pre-emphasized radio frequency signal SRF with the first comparator threshold $c_1$, and said first pulse width modulated signal SPWM1 is sent to a first input of the differential switching power amplifier DSPA.

The pre-emphasized radio frequency signal SRF is also transmitted to a signal input of the second pulse width modulator PWM2, and a second comparator threshold $-c_1$ is fed to a reference input of the second pulse width modulator PWM2. As depicted in the lower diagram in fig. 4 and described above, a second pulse width modulated signal results from a comparison of the pre-emphasized radio frequency signal SRF with the second comparator threshold $-c_1$, and said second pulse width modulated signal is inverted in the signal inverter INV resulting in an inverted second pulse width modulated signal SPWM2. The inverted second pulse width modulated signal SPWM2 is sent to a second input of the differential switching power amplifier DSPA.

In the embodiment depicted in fig. 11, for amplification of the two binary pulse width modulated signals, a differential switching power amplifier DSPA is used. The two inputs of the differential switching amplifier DSPA are fed with the first pulse width modulated signal SPWM1, and with the inverted second pulse width modulated signal SPWM2. Due to the differential operation, the differential switching power amplifier DSPA amplifies separately the two inputs and inherently subtracts them. Thus, for this approach, one of the pulse width modulated output signals needs to be inverted, which is the reason that the binary pulse width modulated signal resulting from the second pulse width modulator PWM2 must be inverted in the signal inverter INV.

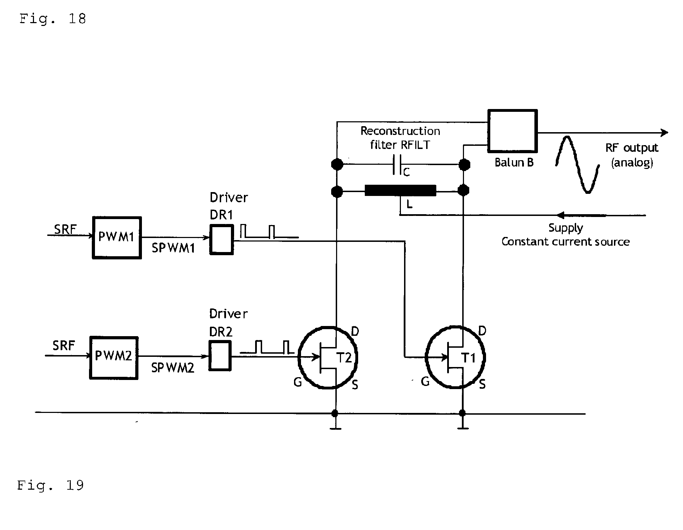

Two examples for an implementation of such a differential switching power amplifier are depicted in figs. 18 and 19, and described below.

The amplification of the first pulse width modulated signal SPWM1, and the inverted second pulse width modulated signal SPWM2 results in a ternary signal SDSPA. Said ternary signal SDSPA corresponds to an amplified copy of a ternary pulse width modulated signal as e.g. depicted in fig. 5.

The ternary signal SDSPA is then filtered in a reconstruction filter RFILT preferably of low pass or band pass type for converting the ternary signal SDSPA into an amplified copy of the upconverted baseband signal SBB.

Thus, according to the embodiment of the invention, the two output signals of the two pulse width modulators PWM1 and PWM2 are amplified in a differential switching power amplifier DSPA, as this is easier than a direct amplification of ternary pulse width modulated signals.

In an embodiment of the invention using a differential switching power amplifier DSPA for amplification of two binary pulse width modulated signals depicted in fig. 12, instead of introducing an inverter, the input signals of one pulse width modulator PWM1 or PWM2 can be exchanged, i.e. the reference signal input, marked with R in fig. 12, and the desired signal input, marked with S in fig. 12, of one pulse width modulator PWM1 or PWM2 are exchanged with each other, which is equivalent to an inversion of the respective pulse width modulated signal.

Thus, the transmitter depicted in fig. 12 in principle corresponds to the transmitter depicted in fig. 11, with the difference, that no inverter INV is used, but instead the inputs for the pre-emphasized radio frequency signal SRF and the second comparator threshold $-c_1$ of the second pulse width modulator PWM2 are exchanged.

In an alternative of the embodiment, in case the pulse width modulators PWM1 and PWM2 provide differential outputs, the inverted output of one pulse width modulator PWM1 or PWM2 can be used instead of exchanging its input ports.

Fig. 13 schematically shows exemplarily a transmitter for amplification of distributed ternary pulse width modulated signals using a pulse width modulator, a splitter, a phase shifter and a differential switching power amplifier according to an embodiment of the invention.

In case the envelope a of the pre-emphasized radio frequency signal $SRF = a*\sin(2\pi f_c t + \varphi)$ is only slowly varying compared to the term $\sin(2\pi f_c t)$, the inverted second pulse width modulated signal SPWM2 as depicted in fig. 11 and 12 and described above can be approximated as a phase shifted, i.e. delayed version of the first pulse width modulated signal SPWM1. If the bandwidth of the baseband signal is small compared to the carrier frequency $f_c$, this approximation is very exact. This allows a further simplified implementation of an embodiment of the invention as depicted in fig. 13.

The transmitter comprises a pulse width modulator PWM1, a splitter or coupler SPL, a phase shifter or delay PS, a differential switching power amplifier DSPA, and a reconstruction filter RFILT.

The pre-emphasized radio frequency signal $SRF = a*\sin(2\pi f_c t + \varphi)$ as described above is transmitted to a signal input of the pulse width modulator PWM1, and a first comparator threshold $c_1$ is fed to a reference input of the pulse width modulator PWM1. As depicted in the upper diagram in fig. 4 and described above, a first pulse width modulated signal SPWM1 results from a comparison of the pre-emphasized radio frequency signal SRF with the first comparator threshold $c_1$.

Said first pulse width modulated signal SPWM1 is duplicated by means of the splitter or coupler SPL. As in the embodiment in fig. 13 only the functionality of a splitter is required, the usage of a splitter SPL is preferred.

Said first pulse width modulated signal SPWM1 is sent to a first input of the differential switching power amplifier DSPA.

Said first pulse width modulated signal SPWM1 is also transmitted to an input of the phase shifter PS. The phase shifter PS delays the first pulse width modulated signal SPWM1 by a half period of the sine wave at carrier frequency $f_c$, i.e. by $T = 1/2/f_c$, resulting in a second pulse width modulated signal SPWM2, which corresponds to the inverted second pulse width modulated signal SPWM2 as depicted in fig. 11 and 12 and described above.

The inverted second pulse width modulated signal SPWM2 is sent to a second input of the differential switching power amplifier DSPA.

As depicted in fig. 11 and 12 and described above, for amplification of the two binary pulse width modulated signals, the differential switching power amplifier DSPA is used. The two inputs of the differential switching amplifier DSPA are fed with the first pulse width modulated signal SPWM1, and with the inverted second pulse width modulated signal SPWM2. Due to the differential operation, the differential switching power amplifier DSPA amplifies separately the two inputs and inherently subtracts them.

The amplification of the first pulse width modulated signal SPWM1, and the inverted second pulse width modulated signal SPWM2 results in a ternary signal SDSPA. Said ternary signal SDSPA corresponds to an amplified copy of a ternary pulse width modulated signal as e.g. depicted in fig. 5.

The ternary signal SDSPA is then filtered in a reconstruction filter RFILT preferably of low pass or band pass type for converting the ternary signal SDSPA into an amplified copy of the upconverted baseband signal SBB.

In an alternative of the embodiment, instead of the phase shifter PS, an additional printed circuit board track can be used to delay the first pulse width modulated signal SPWM1 by a half period of the sine wave at carrier frequency $f_c$.

A transmitter according to one of the embodiments of the invention as described above can be used as a transmitter for amplification and transmission of signals over an air interface. In such a scenario, a modulation of signals in pulse width modulators can be performed in a base station, whereas an amplification of modulated signals can be performed remotely e.g. in remote radio heads. As it is advantageous with respect to error rate and energy efficiency to transmit modulated signals optically, in the following several embodiments according to the invention with optical transmission of modulated signals are described.

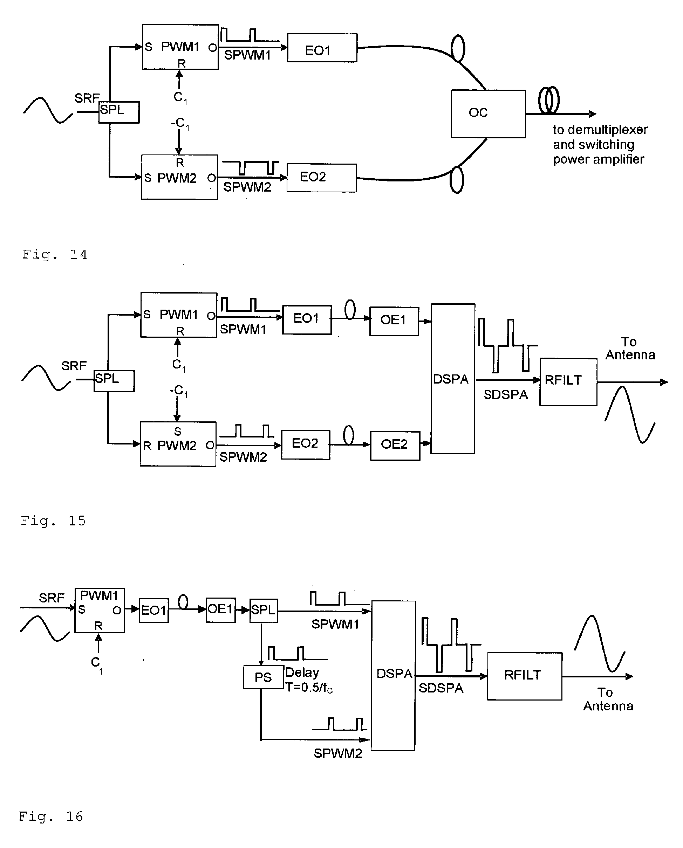

Fig. 14 schematically shows exemplarily a transmitter for amplification of distributed ternary pulse width modulated signals using two pulse width modulators, two electro-optical converters and an optical combiner for optical transmission of pulse width modulated signals to switching power amplifiers according to an embodiment of the invention.

The transmitter comprises a splitter or coupler SPL, a first and a second pulse width modulator PWM1, PWM2, a first and a second electro-optical converter EO1, E02, and an optical combiner OC.

A pre-emphasized radio frequency signal $SRF = a*\sin(2\pi f_c t + \varphi)$ as described above is duplicated by means of the splitter or coupler SPL. As in the embodiment in fig. 14 only the functionality of a splitter is required, the usage of a splitter SPL is preferred.

The pre-emphasized radio frequency signal SRF is transmitted to a signal input of the first pulse width modulator PWM1, and a first comparator threshold $c_1$ is fed to a reference input of the first pulse width modulator PWM1. As depicted in the upper diagram in fig. 4 and described above, a first pulse width modulated signal SPWM1 results from a comparison of the pre-emphasized radio frequency signal SRF with the first comparator threshold $c_1$, and said first pulse width modulated signal SPWM1 is sent to an input of the first electro-optical converter EO1.

In the first electro-optical converter EO1, said first pulse width modulated signal SPWM1, which is a binary pulse width modulated signal, is converted from an electrical signal to an optical signal, and transmitted via an optical connection to a first input of the optical combiner OC.

The pre-emphasized radio frequency signal SRF is also transmitted to a signal input of the second pulse width modulator PWM2, and a second comparator threshold $-c_1$ is fed to a referenceinput of the second pulse width modulator PWM2. As depicted in the lower diagram in fig. 4 and described above, a second pulse width modulated signal SPWM2 results from a comparison of the pre-emphasized radio frequency signal SRF with the second comparator threshold $-c_1$, and said second pulse width modulated signal SPWM2 is sent to an input of the second electro-optical converter E02.

In the second electro-optical converter E02, said second pulse width modulated signal SPWM2, which is a binary pulse width modulated signal, is converted from an electrical signal to an optical signal, and transmitted via an optical connection to a second input of the optical combiner OC.

Depending on the optical multiplexing technique, the electro-optical converters EO1, E02 can either work on the same optical frequency or on different optical frequencies.

From the optical combiner, the first and second optical pulse width modulated signals SPWM1, SPWM2 are transmitted via an optical connection to a demultiplexer and then to switching power amplifiers SPA1 and SPA2 as depicted in fig. 10. The further signal processing is as depicted in fig. 10 and described above. In fig. 14, the demultiplexer and the switching power amplifiers are not depicted for the sake of simplicity.

Fig. 15 schematically shows exemplarily a transmitter for amplification of distributed ternary pulse width modulated signals according to fig. 12, with additionally two electro-optical converters EO1, EO2 and two opto-electrical converters OE1, OE2 for optical transmission of pulse width modulated signals to the differential switching power amplifier according to an embodiment of the invention.

As the embodiment in fig. 15 in principle corresponds to the embodiment depicted in fig. 12, only the differences are described in the following.

The first pulse width modulated signal SPWM1, which is a binary pulse width modulated signal, is transmitted from the first pulse width modulator PWM1 to the first electro-optical converter EO1, and is converted from an electrical signal to an optical signal in the first electro-optical converter EO1. The first optical pulse width modulated signal SPWM1 is then transmitted via an optical connection to the first opto-electrical converter OE1, and is converted from an optical signal to an electrical signal in the first opto-electrical converter OE1. The first opto-electrical converter OE1 is in turn connected to a first input of the differential switching power amplifier DSPA.

The second pulse width modulated signal SPWM2, which is a binary pulse width modulated signal, is transmitted from the second pulse width modulator PWM2 to the second electro-optical converter E02, and is converted from an electrical signal to an optical signal in the second electro-optical converter E02. The second optical pulse width modulated signal SPWM2 is then transmitted via an optical connection to the second opto-electrical converter OE2, and is converted from an optical signal to an electrical signal in the second opto-electrical converter OE2. The second opto-electrical converter OE2 is in turn connected to a second input of the differential switching power amplifier DSPA.

The electro-optical converters EO1, E02 can either work on the same optical frequency or on different optical frequencies.

The further processing of the signals is as described above in fig. 12.

Fig. 16 schematically shows exemplarily a transmitter for amplification of distributed ternary pulse width modulated signals according to fig. 13, with additionally an electro-optical converter EO1 and an opto-electrical converter OE1 for optical transmission of pulse width modulated signals to the differential switching power amplifier according to an embodiment of the invention.

As the embodiment in fig. 16 in principle corresponds to the embodiment depicted in fig. 13, only the differences are described in the following.

The first pulse width modulated signal, which is a binary pulse width modulated signal, is transmitted from the pulse width modulator PWM1 to the electro-optical converter EO1, and is converted from an electrical signal to an optical signal in the electro-optical converter EO1. The first optical pulse width modulated signal SPWM1 is then transmitted via an optical connection to the opto-electrical converter OE1, and is converted from an optical signal to an electrical signal in the opto-electrical converter OE1. The opto-electrical converter OE1 is in turn connected to an input of the splitter or converter SPL.

The further processing of the signals is as described above in fig. 13.

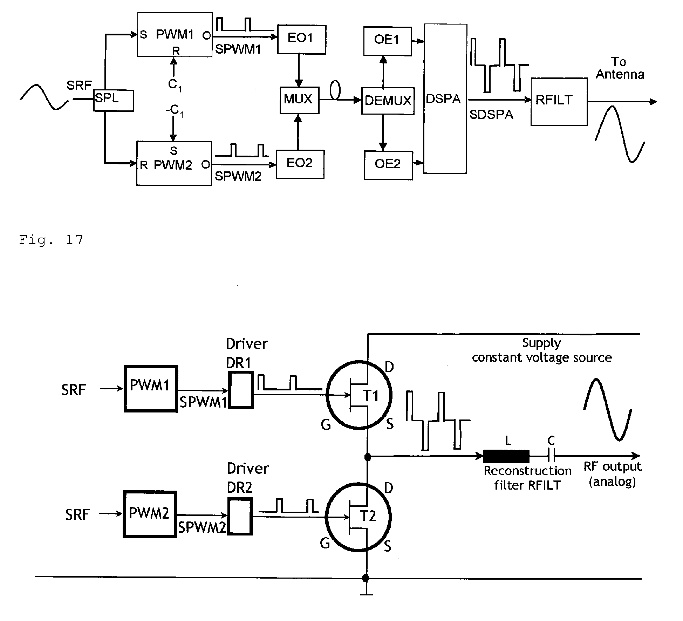

Fig. 17 schematically shows exemplarily a transmitter for amplification of distributed ternary pulse width modulated signals according to fig. 15, with additionally an optical multiplexer MUX and an optical demultiplexer DEMUX for combined optical transmission of pulse width modulated signals to the differential switching power amplifier DSPA according to an embodiment of the invention.

As the embodiment in fig. 17 in principle corresponds to the embodiment depicted in fig. 15, only the differences are described in the following.

From the first electro-optical converter EO1, the first optical pulse width modulated signal SPWM1 is transmitted via an optical connection to a first input of the multiplexer MUX, and from the second electro-optical converter E02, the second optical pulse width modulated signal SPWM2 is transmitted via an optical connection to a second input of the multiplexer MUX.

The first and the second optical pulse width modulated signals SPWM1, SPWM2 are multiplexed and transmitted via a common optical connection from the multiplexer to the demultiplexer DEMUX.

In the demultiplexer DEMUX, the first and the second optical pulse width modulated signals SPWM1, SPWM2 are demultiplexed and transmitted via optical connections to an input of the first opto-electrical converter OE1, and to an input of the second opto-electrical converter OE2 respectively.

The optical multiplexer MUX and demultiplexer DEMUX can be implemented e.g. as optical fibre combiner and splitter respectively, as a wavelength multiplexer and demultiplexer respectively, or as polarisation mode multiplexer and demultiplexer respectively..

The electro-optical multiplexer EO1 and E02 work on different optical frequencies if wavelength multiplexing is used as multiplexing method.

The further processing of the signals is as described above in fig. 15.

In the embodiments described above, the electro-optical converters E01, E02 as described above can be implemented e.g. as a directly modulated laser or as a laser with external optical modulator, as e.g. a Mach-Zehnder modulator or an electro absorption modulator. Instead of a laser, also light emitting diodes (LED) can be used.

The opto-electrical converters OE1, OE2 as described in the embodiments above can be implemented e.g. as a photo diode.

In fig. 18, the principle concept of a differential switching power amplifier system according to the state-of-the-art based on voltage switching is shown exemplarily, which can in principle be used in the respective embodiments described above in figs. 11, 12 and 13. Said differential switching power amplifier system comprises a first and a second pulse width modulator PWM1, PWM2 with inputs for reception of a digital or analogue pre-emphasized radio frequency signal SRF. An output of the first and the second pulse width modulator PWM1 and PWM2 respectively is connected to an input of a first and a second driver DR1 and DR2 respectively.

An output of the driver DR1 is connected to a gate of a first transistor T1, and an output of the driver DR2 is connected to a gate of a second transistor T2.

A source of the first transistor T1 is connected to ground, and a source of the second transistor T2 is connected to a drain of the first transistor T1.

The drain of the first transistor T1 and the source of the second transistor T2 are connected to an RF output via a reconstruction filter RFILT that comprises an inductor L and a capacitor C in series. There are variants of the L-C filter topology which however are of no importance for the invention as disclosed.

A drain of the second transistor T2 is connected to a supply of a constant voltage source.

In a method for signal amplification using a differential voltage switching power amplifier system according to the state-of-the-art as shown in fig. 18, digital or analogue pre-emphasized radio frequency signals SRF as described above are sent to the pulse width modulators PWM1 and PWM2.

In the pulse width modulators PWM1 and PWM2, the digital or analogue pre-emphasized radio frequency signals SRF are converted into a first and a second binary pulse width modulated signal SPWM1 and SPWM2 respectively as described above under fig. 4 by means of comparison of the pre-emphasized radio frequency signals SRF with two different comparator thresholds, and in case of a digital RF input signal using a so-called sample-and-hold output. The first and second binary pulse width modulated signal SPWM1 and SPWM2 respectively with binary amplitude levels is provided at the output of the pulse width modulator PWM1 and PWM2 respectively.

Said first and second binary pulse width modulated signals SPWM1 and SPWM2 are sent to the driver DR1 and DR2 respectively. The driver DR1 generates first driver signals based on the first binary pulse width modulated signal SPWM1, and the driver DR2 generates second driver signals based on inverting the second binary pulse width modulated signal SPWM2.

In an alternative, instead of inverting the second binary pulse width modulated signal SPWM2, the reference signal input, and the desired signal input of the second pulse width modulator PWM2 are exchanged as described under fig. 12.

In a further alternative, instead of inverting the second binary pulse width modulated signal SPWM2, only a first binary pulse width modulated signal SPWM1 is generated in a first pulse width modulator PWM1 and duplicated using a splitter or a coupler, and one of said duplicated signals is phase shifted as described above under fig. 13 leading to the second binary pulse width modulated signal SPWM2.

The first driver signals are sent to the gate of the first transistor T1, and the second driver signals are sent to the gate of the second transistor T2. If the output signal of the first driver DR1 is low, and the output signal of the second driver DR2 is high, then the voltage at the drain of the second transistor T2, and at the source of the first transistor T1 respectively is low, i.e. $V_{Lamp}$. If the output signal of the first driver DR1 is high, and the output signal of the second driver DR2 is low, then the voltage at the drain of the second transistor T2, and at the source of the first transistor T1 respectively is high, i.e. $V_{Hamp}$. If the output signal of both the first driver DR1 and the second driver DR2 is low, then the voltage at the drain of the second transistor T2, and at the source of the first transistor T1 respectively shall be $(V_{Hamp}+V_{Lamp})$ /2.

The described amplifier architecture with two transistors T1, T2 is just an example, and in alternative architectures, more than two transistors are used, which has however no influence on the invention. Such alternative architectures are e.g. multibit architectures, using two transistors more per each bit more.

The gate driving signal for transistor T1 is referenced to the source of T1. As the source of T1 is connected to the RF output, this source potential is floating. For transistor T2 the source potential is connected to ground, i.e. it is static.

The capacitor C and the inductor L together build exemplarily a reconstruction filter RFILT used to generate from amplified ternary pulse width modulated signals smooth analogue output signals that are provided at the RF output.

In fig. 19, a differential switching power amplifier system according to the state-of-the-art based on current switching is shown, which can in principle be used in the respective embodiments described above in figs. 11, 12 and 13. Said differential switching power amplifier system comprises a first and a second pulse width modulator PWM1, PWM2 with inputs for reception of a digital or analogue pre-emphasized radio frequency signal SRF. An output of the first and the second pulse width modulator PWM1 and PWM2 respectively is connected to an input of a first and a second driver DR1 and DR2 respectively.

An output of the driver DR1 is connected to the gate of a first transistor T1, and an output of the driver DR2 is connected to the gate of a second transistor T2.

Both a source of the first transistor T1 and a source of the second transistor T2 are connected to ground.

A drain of the first transistor T1 is connected to a first input of an inductor L and to a first input of a capacitor C, and a drain of the second transistor T2 is connected to a second input of the inductor L and to a second input of the capacitor C. The capacitor C and the inductor L build together a reconstruction filter RFILT. There are variants of the L-C filter topology which however are of no importance for the invention as disclosed.

A supply of a constant current source is connected to a third input of the inductor L.

Furthermore, the drain of the first transistor T1 is connected to a first input of a balun B, and the drain of the second transistor T2 is connected to a second input of the balun B. The balun B transforms a balanced input signal to a single ended signal. At the balun's output an analogue RF output signal is provided.

Preferably, the drivers DR1, DR2 and the transistors T1 and T2 are fabricated in Gallium Nitride (GaN) technology.

In a method for signal amplification using a differential current switching power amplifier system according to the state-of-the-art as shown in fig. 19, digital or analogue pre-emphasized radio frequency signals SRF as described above are sent to the pulse width modulators PWM1 and PWM2.

In the pulse width modulators PWM1 and PWM2, the digital or analogue RF pre-emphasized radio frequency signals SRF are converted into a first and a second binary pulse width modulated signal SPWM1 and SPWM2 respectively as described above under fig. 4 by means of comparison of the pre-emphasized radio frequency signals SRF with two different comparator thresholds, and using a so-called sample-and-hold output. The first and second binary pulse width modulated signal SPWM1 and SPWM2 respectively is provided at the output of the pulse width modulator PWM1 and PWM2 respectively.

Said first and a second binary pulse width modulated signals SPWM1 and SPWM2 are sent to the driver DR1 and DR2 respectively. The driver DR1 generates first driver signals based on the first binary pulse width modulated signal SPWM1, and the driver DR2 generates second driver signals based on inverting the second binary pulse width modulated signal SPWM2.

In an alternative, instead of inverting the second binary pulse width modulated signal SPWM2, the reference signal input, and the desired signal input of the second pulse width modulator PWM2 are exchanged as described under fig. 12.

In a further alternative, instead of inverting the second binary pulse width modulated signal SPWM2, only a first binary pulse width modulated signal SPWM1 is generated in a first pulse width modulator PWM1 and duplicated using a splitter or a coupler, and one of said duplicated signals is phase shifted as described above under fig. 13 leading to the inverted second binary pulse width modulated signal SPWM2.

The first driver signals are sent to the gate of the first transistor T1, and the second driver signals are sent to the gate of the second transistor T2. The signal generation by means of the first and second transistor T1 and T2 is similar as described above under fig. 18. The described amplifier architecture with two transistors T1, T2 is just an example, and in alternative architectures, more than two transistors are used, which has however no influence on the invention. Such alternative architectures are e.g. multibit architectures, using two transistors more per each bit more.

In the first transistor T1 and in the second transistor T2, the first driver signals and the second driver signals respectively are amplified resulting in first and a second amplifier signals.

The capacitor C and the inductor L build together an exemplary reconstruction filter RFILT used to generate smooth analogue signals out of the first and the second amplifier signals.

The smoothed first and second analogue signals are sent to the balun B, in which the smoothed first and second analogue signals are added together, thus removing common or identical distortions of the input signals of the balun B. In other words, the balun B converts balanced signals to unbalanced signals. The unbalanced RF output signals are provided at the output of the balun B.

In the embodiments described above, out of a pre-emphasized signal, a distributed ternary pulse width modulated signal is generated which is composed out of two binary pulse width modulated signals. However, generally a pre-emphasized signal can also be converted into an arbitrary distributed multi-level signal which is composed out of multiple binary pulse width modulated signals by means of using multiple pulse width modulators with different comparator thresholds, amplifying the multiple binary pulse width modulated signals, and adding the amplified multiple binary pulse width modulated signals.

As an example for an application of a transmitter according to the invention, a base station in a wireless communication network can comprise a transistor according to one of the embodiments described above, and an antenna network for transmission of signals over an air interface.

**Claims**

1. A method for pulse width modulation of a signal (SBB) using at least two pulse width modulators (PWM1, PWM2), wherein

   • a pre-emphasis of the signal (SBB) dependent on a first comparator threshold ($c_1$) of a first pulse width modulator (PWM1) of said at least two pulse width modulators (PWM1, PWM2) is performed with a subsequent upconversion to a radio frequency resulting in a pre-emphasized radio frequency signal (SRF) with an envelope (a) above said first comparator threshold ($c_1$),

• the pre-emphasized radio frequency signal (SRF) is compared to said first threshold ($c_1$) in said first pulse width modulator (PWM1) of said at least two pulse width modulators (PWM1, PWM2),

• the pre-emphasized radio frequency signal (SRF) is compared to a second threshold ($-c_1$) in a second pulse width modulator (PWM2) of said at least two pulse width modulators (PWM1, PWM2),

• a first pulse width modulated signal (SPWM1) is generated by means of pulses (P1) that are generated when a difference between said pre-emphasized radio frequency signal (SRF) and said first threshold ($c_1$) has a first predefined algebraic sign,

• and a second pulse width modulated signal (SPWM2) is generated by means of pulses (P2) that are generated when a difference between said pre-emphasized radio frequency signal (SRF) and said second threshold ($-c_1$) has a second predefined algebraic sign.

2. A method according to claim 1 , wherein

• phase ($\varphi$) and magnitude (x) of the signal (SBB) are split,
• said pre-emphasis of the signal (SBB) is performed on the magnitude (x) of the signal (SBB) resulting in a pre-emphasized magnitude (a),
• and the pre-emphasized magnitude (a) and the phase ($\varphi$) of the signal (SBB) are used for said upconversion to the radio frequency by a mixer (MIX) resulting in said pre-emphasized radio frequency signal (SRF).

3. A method according to claim 1, wherein

• after the pre-emphasis of the signal (SBB) phase ($\varphi$) and pre-emphasized magnitude (a) are split,
• and the pre-emphasized magnitude (a) and the phase ($\varphi$) are used for said upconversion to the radio frequency by a mixer (MIX) resulting in said pre-emphasized radio frequency signal (SRF)

4. A method according to claim 1 , wherein the pre-emphasis of the signal (SBB) is performed by pre-emphasis of the absolute value of the signal (SBB).

5. A method according to claim 1, wherein

• The first pulse width modulated signal (SPWM1) is amplified in a first switching power amplifier (SPA1) resulting in a first amplified modulated signal (SSPA1),
• the second pulse width modulated signal (SPWM2) is amplified in a second switching power amplifier (SPA2) resulting in a second amplified modulated signal (SSPA2),
• and the first amplified modulated signal (SSPA1) and the second amplified modulated signal (SSPA2) are combined resulting in a three level signal (SSPA).

6. A method according to claim 1, wherein the first pulse width modulated signal (SPWM1) and the second pulse width modulated signal (SPWM2) are amplified in a differential switching power amplifier (DSPA).

7. A method according to claim 6, wherein one of said first pulse width modulated signal (SPWM1) and said second pulse width modulated signal (SPWM2) is inverted before amplification in said differential switching power amplifier (DSPA).

8. A method according to claim 6, wherein in one of said first pulse width modulator (PWM1) and said second pulse width modulator (PWM2), the pre-emphasized radio frequency signal (SRF) is fed to an input for a reference signal, and a reference signal indicating a threshold ($c_1$, $-c_1$) is fed to an input for a data signal.

9. A method according to any of the preceding claims, wherein at least one pulse width modulated signal (SPWM1, SPWM2) is converted from an electrical signal to an optical signal in at least one electro-optical converter (EO1, E02), transmitted over at least one optical connection, and converted from an optical signal to an electrical signal in at least one opto-electrical converter (OE1, OE2).

10. A transmitter comprising at least two pulse width modulators (PWM1, PWM2) for pulse width modulation of a signal (SBB), wherein said transmitter is adapted to

• perform a pre-emphasis of the signal (SBB) dependent on a first comparator threshold ($c_1$) of a first pulse width modulator (PWM1) of said at least two pulse width modulators (PWM1, PWM2) and perform an upconversion to a radio frequency resulting in a pre-emphasized radio frequency signal (SRF) with an envelope (a) above said first comparator threshold ($c_1$),

• compare the pre-emphasized radio frequency signal (SRF) to said first threshold ($c_1$) in said first pulse width modulator (PWM1) of said at least two pulse width modulators (PWM1, PWM2),

• generate a first pulse width modulated signal (SPWM1) by means of pulses (P1) that are generated when a difference between said pre-emphasized radio frequency signal (SRF) and said first threshold ($c_1$) has a first predefined algebraic sign,

• compare the pre-emphasized radio frequency signal (SRF) to a second threshold ($-c_1$) in a second pulse width modulator (PWM2) of said at least two pulse width modulators (PWM1, PWM2),

• and generate a second pulse width modulated signal (SPWM2) by means of pulses (P2) that are generated when a difference between said pre-emphasized radio frequency signal (SRF) and said second threshold ($-c_1$) has a second predefined algebraic sign.

**11.** A base station comprising a transmitter according to claim 10 and at least one antenna network for transmission of signals over an air interface.

**Patentansprüche**

**1.** Verfahren zur Pulsweitenmodulation eines Signals (SBB) unter Verwendung von mindestens zwei Pulsweitenmodulatoren (PWM1, "WM2), wobei

• eine Vorverzerrung des Signals (SBB) in Abhängigkeit von einer ersten Komparatorschwelle ($c_1$) eines ersten Pulsweitenmodulators (PWM1) der besagten mindestens zwei Pulsweitenmodulatoren (PWM1, PWM2) mit einer anschließenden Aufwärtswandlung auf eine Funkfrequenz durchgeführt wird, wodurch ein vorverzerrtes Funkfrequenzsignal (SRF) mit einer Hüllkurve (a) oberhalb der besagten ersten Komparatorschwelle (c1) entsteht,

• das vorverzerrte Funkfrequenzsignal (SRF) mit der besagten ersten Schwelle ($c_1$) in dem besagten ersten Pulsweitenmodulator (PWM1) der besagten mindestens zwei Pulsweitenmodulatoren (PWM1, PWM2) verglichen wird,

• das vorverzerrte Funkfrequenzsignal (SRF) mit einer zweiten Schwelle ($-c_1$) in einem zweiten Pulsweitenmodulator (PWM2) der besagten mindestens zwei Pulsweitenmodulatoren (PWM1, PWM2) verglichen wird,

• ein erstes pulsweitenmoduliertes Signal (SPWM1) anhand von Pulsen (P1), welche erzeugt werden, wenn eine Differenz zwischen dem besagten vorverzerrten Funkfrequenzsignal (SRF) und der besagten ersten Schwelle ($c_1$) ein erstes vordefiniertes Vorzeichen aufweist, erzeugt wird,

• und ein zweites pulsweitenmoduliertes Signal (SPWM2) anhand von Pulsen (P2), welche erzeugt werden, wenn eine Differenz zwischen dem besagten vorverzerrten Funkfrequenzsignal (SRF) und der besagten zweiten Schwelle ($-c_1$) ein zweites vordefiniertes Vorzeichen aufweist, erzeugt wird.

**2.** Verfahren nach Anspruch 1, wobei

• die Phase ($\varphi$) und die Größe (x) des Signals (SBB) aufgespalten werden,

• die besagte Vorverzerrung des Signals (SBB) auf einer Größe (x) des Signals (SBB) durchgeführt wird, wodurch eine vorverzerrte Größe (a) entsteht,

• und die vorverzerrte Größe (a) und die Phase ($\varphi$) des Signals (SBB) für die besagte Aufwärtswandlung auf die Funkfrequenz durch einen Mischer (MIX) verwendet werden, wodurch das besagte vorverzerrte Funkfrequenzsignal (SRF) entsteht.

**3.** Verfahren nach Anspruch 1, wobei

• nach der Vorverzerrung des Signals (SBB) die Phase ($\varphi$) und die vorverzerrte Größe (a) aufgespalten werden,

• und die vorverzerrte Größe (a) und die Phase ($\varphi$) für die besagte Aufwärtswandlung auf die Funkfrequenz durch einen Mischer (MIX) verwendet werden, wodurch das besagte vorverzerrte Funkfrequenzsignal (SRF) entsteht.

**4.** Verfahren nach Anspruch 1, wobei die Vorverzerrung des Signals (SBB) durch die Vorverzerrung des absoluten Wertes des Signals (SBB) durchgeführt wird.

5. Verfahren nach Anspruch 1, wobei

• das erste pulsweitenmodulierte Signal (SPWM1) in einem ersten Schalt-Leistungsverstärker (SPA1) verstärkt wird, wodurch das erste verstärkte modulierte Signal (SSPA1) entsteht,
• das zweite pulsweitenmodulierte Signal (SPWM2) in einem zweiten Schalt-Leistungsverstärker (SPA2) verstärkt wird, wodurch ein zweites verstärktes moduliertes Signal (SSPA2) entsteht,
• und das erste verstärkte modulierte Signal (SSPA1) und das zweite verstärkte modulierte Signal (SSPA2) kombiniert werden, wodurch ein Dreipegel-Signal (SSPA) entsteht.

6. Verfahren nach Anspruch 1, wobei das erste pulsweitenmodulierte Signal (SPWM1) und das zweite pulsweitenmodulierte Signal (SPWM2) in einem Schalt-Differenzleistungsverstärker (DSPA) verstärkt werden.

7. Verfahren nach Anspruch 6, wobei entweder das besagte erste pulsweitenmodulierte Signal (SPWM1) oder das besagte zweite pulsweitenmodulierte Signal (SPWM2) vor der Verstärkung in dem besagten Schalt-Differenzleistungsverstärker (DSPA) invertiert wird.

8. Verfahren nach Anspruch 6, wobei das vorverzerrte Funkfrequenzsignal (SRF) entweder in dem besagten ersten Pulsweitenmodulator (PWM1) oder in dem besagten zweiten Pulsweitenmodulator (PWM2) in einen Eingang für ein Referenzsignal eingespeist wird, und ein Referenzsignal, welches eine Schwelle ($c_1$, - $c_1$) anzeigt, in einen Eingang für ein Datensignal eingespeist wird.

9. Verfahren nach einem beliebigen der vorstehenden Ansprüche, wobei zumindest ein pulsweitenmoduliertes Signal (SPWM1, SPWM2) in mindestens einem elektrooptischen Wandler (EO1 EO2) von einem elektrischen Signal in ein optisches Signal umgewandelt, über zumindest eine optische Verbindung übertragen und in mindestens einem opto-elektrischen Wander (OE1, OE2) von einem optischen Signal in ein elektrisches Signal umgewandelt wird.

10. Sender mit mindestens zwei Pulsweitenmodulatoren (PWM1, PWM2) für die Pulsweitenmodulation eines Signals (SBB), wobei der besagte Sender für das Durchführen der folgenden Schritte ausgelegt ist:

• Durchführen einer Vorverzerrung des Signals (SBB) in Abhängigkeit von einer ersten Komparatorschwelle ($c_1$) eines ersten Pulsweitenmodulators (PWM1) der besagten mindestens zwei Pulsweitenmodulatoren (PWM1, PWM2), und Durchführen einer Aufwärtswandlung auf eine Funkfrequenz, wodurch ein vorverzerrtes Funkfrequenzsignal (SRF) mit einer Hüllkurve (a) oberhalb der besagten ersten Komparatorschwelle (c1) entsteht,
• Vergleichen des vorverzerrten Funkfrequenzsignals (SRF) mit der besagten ersten Schwelle ($c_1$) in dem besagten ersten Pulsweitenmodulator (PWM1) der besagten mindestens zwei Pulsweitenmodulatoren (PWM1, PWM2),
• Erzeugen eines ersten pulsweitenmodulierten Signals (SPWM1) anhand von Pulsen (P1), welche erzeugt werden, wenn eine Differenz zwischen dem besagten vorverzerrten Funkfrequenzsignal (SRF) und der besagten ersten Schwelle ($c_1$) ein erstes vordefiniertes Vorzeichen aufweist,
• Vergleichen des vorverzerrten Funkfrequenzsignals (SRF) mit einer zweiten Schwelle ($-c_1$) in einem zweiten Pulsweitenmodulator (PWM2) der besagten mindestens zwei Pulsweitenmodulatoren (PWM1, PWM2),
• und Erzeugen eines zweiten pulsweitenmodulierten Signals (SPWM2) anhand von Pulsen (P2), welche erzeugt werden, wenn eine Differenz zwischen dem besagten vorverzerrten Funkfrequenzsignal (SRF) und der besagten zweiten Schwelle ($-c_1$) ein zweites vordefiniertes Vorzeichen aufweist.

11. Basisstation, umfassend einen Sender gemäß Anspruch 10, und mindestens ein Antennennetzwerk für die Übertragung von Signalen über eine Luftschnittstelle.

**Revendications**

1. Procédé de modulation d'impulsions en durée d'un signal (SBB) en utilisant au moins deux modulateurs d'impulsions en durée (PWM1, PWM2) dans lequel

• une préaccentuation du signal (SBB) en fonction d'un premier seuil du comparateur ($c_1$) d'un premier modu-

lateur d'impulsions en durée (PWM1) desdits au moins deux modulateurs d'impulsions en durée (PWM1, PWM2) est réalisée avec une conversion ascendante ultérieure en radiofréquence ce qui a pour résultat un signal de radiofréquence préaccentué (SRF) avec une enveloppe (a) supérieure audit premier seuil du comparateur ($c_1$),

• le signal de radiofréquence préaccentué (SRF) est comparé audit premier seuil ($c_1$) dans ledit premier modulateur d'impulsions en durée (PWM1) desdits au moins deux modulateurs d'impulsions en durée (PWM1, PWM2),

• le signal de radiofréquence préaccentué (SRF) est comparé à un deuxième seuil ($-c_1$) dans un deuxième modulateur d'impulsions en durée (PWM2) desdits au moins deux modulateurs d'impulsions en durée (PWM1, PWM2),

• un premier signal de modulation d'impulsions en durée (SPWM1) est généré au moyen d'impulsions (P1) qui sont générées lorsqu'une différence entre ledit signal de radiofréquence préaccentué (SRF) et ledit premier seuil ($c_1$) présente un premier signe algébrique prédéfini,

• et un deuxième signal de modulation d'impulsions en durée (SPWM2) est généré au moyen d'impulsions (P2) qui sont générées lorsqu'une différence entre ledit signal de radiofréquence préaccentué (SRF) et ledit deuxième seuil ($-c_1$) présente un deuxième signe algébrique prédéfini.

2. Procédé selon la revendication 1, dans lequel

• la phase ($\varphi$) et l'amplitude (x) du signal (SBB) sont divisées,

• ladite préaccentuation du signal (SBB) est réalisée sur l'amplitude (x) du signal (SBB) ce qui a pour résultat une amplitude préaccentuée (a),

• et l'amplitude préaccentuée (a) et la phase ($\varphi$) du signal (SBB) sont utilisées pour ladite conversion ascendante en radiofréquence par un mélangeur (MIX), ce qui a pour résultat ledit signal de radiofréquence préaccentué (SRF).

3. Procédé selon la revendication 1, dans lequel

• après la préaccentuation du signal (SBB), la phase ($\varphi$) et l'amplitude préaccentuée (a) sont divisées,

• et l'amplitude préaccentuée (a) et la phase ($\varphi$) sont utilisées pour ladite conversion ascendante en radiofréquence par un mélangeur (MIX), ce qui a pour résultat ledit signal de radiofréquence préaccentué (SRF).

4. Procédé selon la revendication 1, dans lequel la préaccentuation du signal (SBB) est réalisée par la préaccentuation de la valeur absolue du signal (SBB).

5. Procédé, selon la revendication 1, dans lequel

• le premier signal de modulation d'impulsions en durée (SPWM1) est amplifié dans un premier amplificateur de puissance de commutation (SPA1) ce qui a pour résultat un premier signal modulé amplifié (SSPA1)

• le deuxième signal de modulation d'impulsions en durée (SPWM2) est amplifié dans un deuxième amplificateur de puissance de commutation (SPA2) ce qui a pour résultat un deuxième signal modulé amplifié (SSPA2)

• et le premier signal modulé amplifié (SSPA1) et le deuxième signal modulé amplifié (SSPA2) sont combinés ce qui a pour résultat un signal à trois niveaux (SSPA).

6. Procédé selon la revendication 1, dans lequel le premier signal de modulation d'impulsions en durée (SPWM1) et le deuxième signal de modulation d'impulsions en durée (SPWM2) sont amplifiés dans un amplificateur de puissance de commutation différentiel (DSPA).

7. Procédé selon la revendication 6, dans lequel ledit premier signal de modulation d'impulsions en durée (SPWM1) ou ledit deuxième signal de modulation d'impulsions en durée (SPWM2) est inversé avant l'amplification dans ledit amplificateur de puissance de commutation différentiel (DSPA).

8. Procédé selon la revendication 6, dans lequel dans ledit premier modulateur d'impulsions en durée (PWM1) ou ledit deuxième modulateur d'impulsions en durée (PWM2), le signal de radiofréquence préaccentué (SRF) est envoyé à une entrée en tant que signal de référence, et un signal de référence indiquant un seuil ($c_1$, $-c_1$) est envoyé à une entrée en tant que signal de données.

9. Procédé selon l'une quelconque des revendications précédentes, dans lequel au moins un signal de modulation d'impulsions en durée (SPWM1, SPWM2) est converti d'un signal électrique en un signal optique dans au moins un convertisseur électro-optique (EO1, EO2), transmis sur au moins une connexion optique, et converti d'un signal optique en un signal électrique dans au moins un convertisseur opto-électrique (OE1, OE2).

10. Émetteur comprenant au moins deux modulateurs d'impulsions en durée (PWM1, PWM2) pour la modulation d'impulsions en durée d'un signal (SBB), ledit émetteur étant adapté pour

• réaliser une préaccentuation du signal (SBB) en fonction d'un premier seuil du comparateur ($c_1$) d'un premier modulateur d'impulsions en durée (PWM1) desdits au moins deux modulateurs d'impulsions en durée (PWM1, PWM2) et réaliser une conversion ascendante en radiofréquence ce qui a pour résultat un signal de radiofréquence préaccentué (SRF) avec une enveloppe (a) supérieure audit premier seuil du comparateur ($c_1$),
• comparer le signal de radiofréquence préaccentué (SRF) audit premier seuil ($c_1$) dans ledit premier modulateur d'impulsions en durée (PWM1) desdits au moins deux modulateurs d'impulsions en durée (PWM1, PWM2),
• générer un premier signal de modulation d'impulsions en durée (SPWM1) au moyen d'impulsions (P1) qui sont générées lorsqu'une différence entre ledit signal de radiofréquence préaccentué (SRF) et ledit premier seuil ($c_1$) présente un premier signe algébrique prédéfini,
• comparer le signal de radiofréquence préaccentué (SRF) à un deuxième seuil ($-c_1$) dans un deuxième modulateur d'impulsions en durée (PWM2) desdits au moins deux modulateurs d'impulsions en durée (PWM1, PWM2),
• et générer un deuxième signal de modulation d'impulsions en durée (SPWM2) au moyen d'impulsions (P2) qui sont générées lorsqu'une différence entre ledit signal de radiofréquence préaccentué (SRF) et ledit deuxième seuil ($-c_1$) présente un deuxième signe algébrique prédéfini.

11. Station de base comprenant un émetteur selon la revendication 10 et au moins un réseau d'antennes pour la transmission de signaux sur une interface radio.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

**EP 2 575 309 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6762704 B1